**Europäisches Patentamt**

**European Patent Office**

**Office européen des brevets**

(19)

(11) Veröffentlichungsnummer: **0 254 207**
**A2**

(12) **EUROPÄISCHE PATENTANMELDUNG**

(21) Anmeldenummer: 87110282.8

(22) Anmeldetag: 16.07.87

(51) Int. Cl.⁴: **H03M 1/22** , G01D 5/12

(30) Priorität: 23.07.86 DE 3624874

(43) Veröffentlichungstag der Anmeldung:
27.01.88 Patentblatt 88/04

(84) Benannte Vertragsstaaten:
AT BE CH DE ES FR GB GR IT LI NL SE

(71) Anmelder: **Drecoll, Harm**
**Lessingstrasse 1 A**
**D-4050 Mönchengladbach(DE)**

(72) Erfinder: **Drecoll, Harm**
**Lessingstrasse 1 A**
**D-4050 Mönchengladbach(DE)**

(74) Vertreter: **Patentanwaltsbüro Cohausz &**
**Florack**
**Postfach 14 01 47**
**D-4000 Düsseldorf 1(DE)**

(54) **Winkelgeber.**

(57) Die Erfindung betrifft einen Wegstreckenmesser oder Winkelgeber mit zwei zueinander beweglichen Teilen, von denen ein Teil ein Leseteil und das andere Teil eine Spur trägt, wobei die Spur dem Leseteil Informationen übergibt, die die Stellung der Spur zum Leseteil angeben. Die Spur ist von einer Magnetschicht gebildet und von einem Computer lesbar. Die Informationen der Spur entsprechen den Strecken-bzw. Winkelgraden. Das Leseteil weist einen auf magnetische Stellen ansprechenden Lesekopf auf.

Fig. 1

EP 0 254 207 A2

## Winkelgeber

Die Erfindung betrifft einen Wegstreckenmesser oder einen Winkelgeber mit zwei zueinander beweglichen Teilen, von denen ein Teil ein Leseteil und das andere Teil eine Spur trägt, wobei die Spur dem Leseteil Informationen übergibt, die die Stellung der Spur zum Leseteil angeben.

Winkelgeber werden zur Angabe der Drehstellung zweier Teile zueinander bei den verschiedensten Vorrichtungen eingesetzt. Insbesondere werden sie bei Mehrgelenkarmen im Bereich der Gelenke verwendet. So kann durch einen solchen Mehrgelenkarm die Oberfläche eines Körpers abgetastet werden um hierdurch einem Computer die exakte Oberfläche zu übermitteln.

Die, bisher verwendeten Winkelgeber verwenden eine Code-Scheibe aus transparentem Material, auf der in mehreren Spuren geschwärzte Stellen von einer Lichtquelle mit einer angeschlossenen Photodiode auf der anderen Seite der Scheibe abgetastet werden um die exakte Drehstellung der Scheibe anzugeben. Obwohl auf dieser Scheibe mehrere kreisförmige Endlosspuren vorhanden sind, ist die Anzahl der einzelnen Codeinformationen auf den Spuren nicht genau genug um sehr kleine Winkel anzugeben.

Einer verbesserten Genauigkeit steht die Art der benutzten Bausteine im Wege. G AS-Dioden und Fototransistoren können nicht in kleineren Abständen arbeiten. Es sei sie sind teure Spezialentwicklungen. Theoretisch lassen sich Codefelder bis 0.002 mm aufätzen, aber die Licht und Empfangselemente können mit dieser Feinheit nicht arbeiten.

Durch Einbau einer Übersetzung zwischen den beiden relativ zueinander verdrehbaren Teilen hat man versucht, die Genauigkeit zu erhöhen, aber es wurden auch hier nicht Winkel kleiner als 0,1 Grad erreicht. Dies liegt u.a. an dem Spiel mechanischer Getriebe.

Auch sind Wegstreckenmesser bekannt, die in regelmäßigen Abständen Markierungen aufweisen, die vom Leseteil gelesen werden. Das Erstellen einer solchen Spur ist aufwendig und die Genauigkeit aufgrund der verhältnismäßig großen Abstände der Markierungen voneinander gering.

Aufgabe der Erfindung ist es, einen Wegstreckenmesser oder einen Winkelgeber zu schaffen, der bei mechanisch einfacher Konstruktion und kleiner Bauweise eine hohe Genauigkeit besitzt.

Diese Aufgabe wird erfindungsgemäß dadurch gelöst, daß die Spur von einer Magnetschicht gebildet und von einem Computer lesbar ist, daß die Informationen der Spur den Strecken-bzw. Winkelgraden entsprechen, und daß das Leseteil einen auf magnetische Stellen ansprechenden Lesekopf aufweist.

Ein solcher Wegstreckenmesser oder Winkelgeber nutzt die bereits bei Magnetspeichern, insbesondere bei Magnetplatten und Magnetbändern vorhandene Technik und erreicht bei einfacher Konstruktion und größter Übertragungssicherheit eine sehr hohe Codedichte auf der oder den Spuren, so daß um wenigstens eine Potenz die Genauigkeit erhöht wird. Der Wegstreckenmesser oder Winkelgeber arbeitet mit üblichen Bauteilen, insbesondere mit einem üblichen Lesekopf, wie er bereits für das Lesen von Aufzeichnungsspuren der Computertechnik verwendet wird. Auch können sehr kleine Außenabmessungen erreicht werden. Bei Winkelgebern sind Getriebe nicht erforderlich, so daß sie weitgehend störungsfrei sind.

Alternativ wird zur Lösung der obengenannten Aufgabe vorgeschlagen, daß die Spur von einer Fläche gebildet ist, die von einem Laser mit von einem Computer erzeugten, insbesondere binären Zeichen beschrieben ist, die den Strecken-bzw. Winkelgraden der Spur entsprechen, und daß das Leseteil einen Laser aufweist. Diese Lösung zeichnet sich durch dieselben obengenannten Vorteile aus.

Eine weitere alternative Lösung der erfindungsgemäßen Aufgabe wird vorgeschlagen bei Wegstreckenmessern und Winkelgebern mit zwei zueinander beweglichen Teilen, von denen ein Teil ein Leseteil und das andere Teil eine Spur auf einer transparenten Fläche trägt, wobei die Spur dem eine Photodiode aufweisenden Leseteil Informationen übergibt, die die Stellung der Spur zum eine Photodiode aufweisenden Leseteil angeben.

Bei solchen Wegstreckenmessern oder Winkelgebern wird vorgeschlagen, daß die transparente Fläche mit von einem Computer erzeugten binären Zeichen versehen ist, die den Strecken-bzw. Winkelgraden der Spur entsprechen. Diese Lösung zeigt wiederum dieselben eingangs genannten Vorteile.

Besonders vorteilhaft ist es, wenn die Spur mit einem Code beschrieben ist, der ohne weitere Umrechnung eine direkte Information über die Stellung von Spur und Lesekopf zueinander gibt. Hierdurch werden keine Umrechnungen der Codesignale erforderlich, sondern das auf der Spur gespeicherte Codesignal gibt selber direkt die Stellung an.

Alternativ wird vorgeschlagen, daß der Code aus einer Folge gleicher Zeichen, insbesondere gleicher Bits besteht. Hierbei braucht durch den Lesekopf nur die Anzahl der vorbeistreichenden Bits abgezählt zu werden um hierüber durch eine minimale Rechnung die Stellung angeben zu können. Alternativ kann aber auch der Code ein Dezimalcode sein.

Die Spur oder die Spuren können auf unterschiedlichen und unterschiedlich geformten Trägerflächen angeordnet sein. Eine besonders einfache und geringe Außenabmessungen aufweisende Bauweise wird dann erreicht, wenn die die Endlosspur aufweisende Fläche zylindrisch ist. Hierbei kann die die Endlosspur aufweisende Fläche von der Außen-und/oder Innenseite eines Zylindermantels getragen sein.

Alternativ wird aber auch vorgeschlagen, daß die die Endlosspur aufweisende Fläche kreisscheibenförmig ist. Hierbei kann die die Endlosspur aufweisende Fläche von einer und/oder beiden Seitenflächen einer Kreisscheibe getragen sein.

Für eine einfache und leichte Bauweise wird vorgeschlagen, daß der Träger der Spur aus Kunststoff ist.

Eine sehr vorteilhafte Bauweise wird dann erreicht, wenn die die Endlosspur aufweisende Fläche an der Drehachse des Winkelgebers fest ist und mit dieser gegenüber dem Leseteil und dem Gehäuse verdrehbar ist. Alternativ kann aber auch das Leseteil an der Drehachse des Winkelgebers fest sein und mit dieser gegenüber der Endlosspur und dem Gehäuse verdrehbar sein.

Eine weitere sehr genaue und störunanfällige Aufzeichnungsspur wird dann erreicht, wenn zur Bildung der Spur in nicht magnetischer Substanz, insbesondere Kunststoff eine Reihe von Vertiefungen eingebracht werden. Hierdurch kann die bereits bekannte, für Video-und Musikaufnahmen als auch für Programm-Speicher verwendete Compakt-Disc-Technik Anwendung finden.

Von besonderem Vorteil ist es, wenn der erfindungsgemäße Winkelgeber bei Vorrichtungen zum Erfassen Dreidimensionaler Oberflächen mit mehr Gelenkarmen eingesetzt wird, da es hier besonders auf die Genauigkeit als auch auf geringe Außenabmessungen, geringes Gewicht und Störunanfälligkeit als auch auf Preiswürdigkeit ankommt.

Ausführungsbeispiele der Erfindung sind in den Zeichnungen in axialen Schnitten dargestellt und werden im folgenden näher beschrieben. Es zeigen:

Fig. 1 einen Schnitt durch ein erstes Ausführungsbeispiel eines Winkelgebers mit einer zylindrischen transparenten Fläche, die den Code trägt und die durch einen Lichtlesekopf mit einem Fotoelement abgetastet wird,

Fig. 2 ein zweites Ausführungsbeispiel eines Winkelgebers mit Magnetspuren und Magnetleseköpfen, wobei die Magnetschicht auf der Innenseite eines auf der Achse befestigten Zylinders angeordnet ist,

Fig. 3 ein drittes Ausführungsbeispiel eines Winkelgebers mit auf der Achse befestigten Magnetleseköpfen, die eine auf der zylindrischen Gehäuseinnenseite angeordnete Magnetschicht lesen,

Fig. 4 ein viertes Ausführungsbeispiel eines Winkelgebers mit einer auf der Achse befestigten Kreisscheibe, deren beide Seitenflächen in Spuren angeordnete deformierte Stellen aufweisen, die von Lasern abgetastet werden,

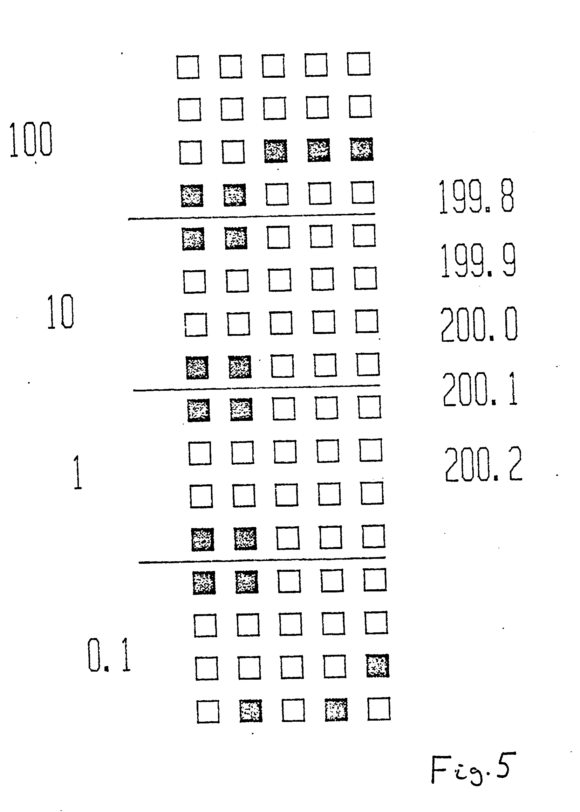

Fig. 5 einen kleinen Ausschnitt aus einer linearen oder gekrümmten endlosen Aufzeichnung eines Winkelgebers oder Wegstreckenmessers mit vier übereinander angeordneten Endlosspuren aus einzelnen Bits und

Fig. 6 einen Ausschnitt aus einer Spur nach Fig. 5, die einen permanenten Nonius bildet.

Eines der wichtigsten Merkmale dieses Wegstreckenmessers oder Winkelgebers ist es, daß die die Winkel-oder Wegstreckeninformationen oder entsprechende Informationen enthaltende Spur exakt einer digitalen Aufzeichnungsspur entspricht, wie sie zum Aufzeichnen von Computerdaten bei den dort verwendeten Aufzeichnungsvorrichtungen verwendet werden. Hierbei wird die Spur, insbesondere Endlosspur entweder von einer Magnetschicht 1, einer Oberfläche einer Kunststoffplatte 2 oder einer transparenten Fläche 3 gebildet. Der Leseteil ist ein üblicher Lesekopf, wie er bei diesen drei bekannten Speicherverfahren verwendet wird. Damit ist das Leseteil entweder ein üblicher Magnetlesekopf 4, ein Laserlesekopf 5 einschließlich der die Laserinformation auffangenden Laserelement bzw. Photodiode oder ein Lichtstrahllesekopf 6 mit dazugehörigem Fotoelement bzw. Fotozelle (Photodiode). Da auf all den obengenannten Aufzeichnungsträgern die Aufzeichnung binär und mit derselben Dichte vorgenommen wurde, wie dies bei den üblichen Computeraufzeichnungen geschieht, wird eine Aufzeichnungsdichte erreicht, wie sie bisher bei Wegstreckenmessern oder Winkelgebern unbekannt war.

Auf den Aufzeichnungsträgern 1, 2, 3 kann eine einzige lineare oder kreisförmige Spur aufgebracht sein. Von Vorteil ist es, mehrere Aufzeichnungsspuren parallel bzw. konzentrisch zueinander anzuordnen um die Informationsdichte und/oder die Sicherheit zu erhöhen. Entsprechend der Anzahl der Spuren sind gleichviele Leseköpfe 4, 5, 6 über den Spuren angeordnet. Alternativ kann auch ein Lesekopf mehrere Spuren abtasten.

Die Form des Aufzeichnungsträgers kann eben, zylindrisch oder scheibenförmig sein, wobei eine oder beide Seitenflächen bzw. Wandungen Spuren, insbesondere Endlosspuren tragen können. Entsprechend sind auch an einer oder beiden Seiten Leseköpfe angeordnet. Auch ist es möglich, daß entweder der Aufzeichnungsträger insbesondere an der Achse 7 bzw. an der Welle des Winkelgebers fest ist und die Leseköpfe am Gehäuse 8 befestigt sind, in der insbesondere die Achse 7 drehbar gelagert ist, oder aber der Aufzeichnungsträger wird vom Gehäuse gebildet oder ist aber an diesem fest und die Leseköpfe sind beweglich.

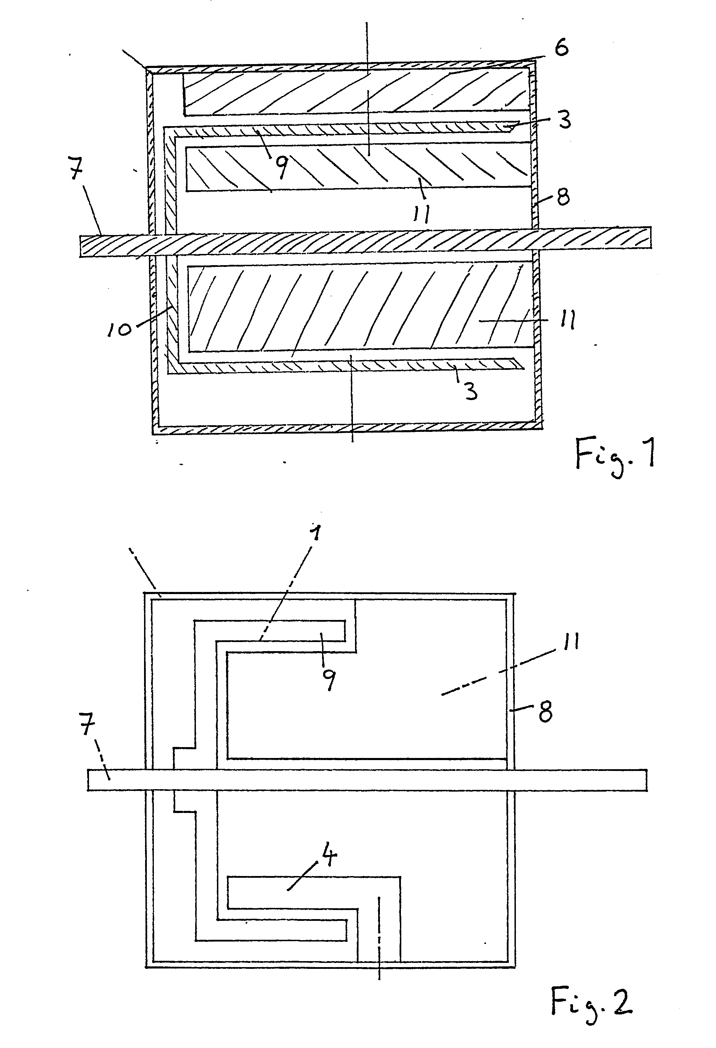

Die Figuren 1 bis 4 zeigen einige der möglichen Konstruktionsarten:

In Figur 1 ist eine Achse 7 in einem koaxialen zylindrischen Gehäuse 8 drehbar gelagert und auf der Achse ist ein koaxialer Zylinder 9 über einen stirnseitigen kreisförmigen Boden 10 befestigt. Der Mantel des Hohlzylinders 9 ist aus transparentem Kunststoff und bildet damit eine transparente zylindrische Fläche 3 auf der durch ein Lichtstrahl erzeugte helle und dunkle Stellen in mehreren parallel nebeneinander liegenden kreisförmigen Spuren angeordnet sind. Diese sehr dichten digitalen Informationen werden durch Lichtstrahlleseköpfe 6 abgetestet, deren Strahlen den Zylinder 9 durchdringen und von außen am Zylinder 9 auf die Innenseite befestigten Fotoelementen 11 aufgefangen werden, die diese Lichtsignale in Stromimpulse umsetzen. Diese Fotoelemente 11 werden von einer G-AS Dioden-Kette gebildet, die parallel zur Achse 7 liegt. Im Zylinder 9 verbleibender Raum ist durch Elektronik ausgefüllt, die am Gehäuse 8 befestigt ist.

Das Ausführungsbeispiel nach Figur 2 weist wiederum einem Zylinder 9 auf, der auf der Achse 7 koaxial fest ist. Der Zylinder besteht aus einem nicht durchsichtigen nicht magnetischem Material, insbesondere aus Kunststoff und besitzt auf der Innenwandung eine Magnetschicht 1, die mehrere Endlosspuren aus digitalen Stellen bzw. Flecken bildet. Diese Magnetschicht ist identisch mit einer Magnetschicht, wie sie auf Computer-Magnetplatten oder Computer-Magnetzylindern besteht. Auf der Magnetschicht befinden sich 8000 bits pro inch (BPI). Die magnetisierbare Schicht kann in Binärform jeden Winkel tragen - in bereits der EDV angepaßten Form - inclusive Error Correction Code, Parity etc. Die Verarbeitung der Signale ist einfach - der Lesekopf arbeitet permanent - streammode - die schwachen Signale werden verstärkt und sind somit in Verbindung mit einer Zeitbasis direkt für die EDV verwendbar. Der Code wird in Längsrichtung auf der Innenseite des Codeträgers aufgespielt, d.h. jede Stellung kann als komplette -absolute Winkeleinheit gelesen werden in binärer Aufzeichnung = XXX,XXX Stellen = 3 x Vorkomma 3 x. Nachkomma = mit Paritätsüberprüfung 49 bit = 6 x 8 bit + 1 bit. Der aktuelle Winkel kann somit als binäre Zahl mit 6 Stellen direkt abgelesen werden - was den Ausdruck absolut darstellt.

Berechnung der Genauigkeit:

Die erste Spur ist 16 bit breit bei 8000 BPI = 500 Winkelinformationen auf 25.401 Millimeter, d.h., Hunderter, Zehner, Einer sind als 4 bis ASCII Code - direkt abzulesen. Bei einem 182,8872 mm Innenumfang des Codeträgers hat er Platz für 3.600 absolute Winkelinformationen = 16bit je Stelle ASCII und damit 4 bits = Auflösung direkt bis 0.1 Winkelgrad mit einem Kopf.

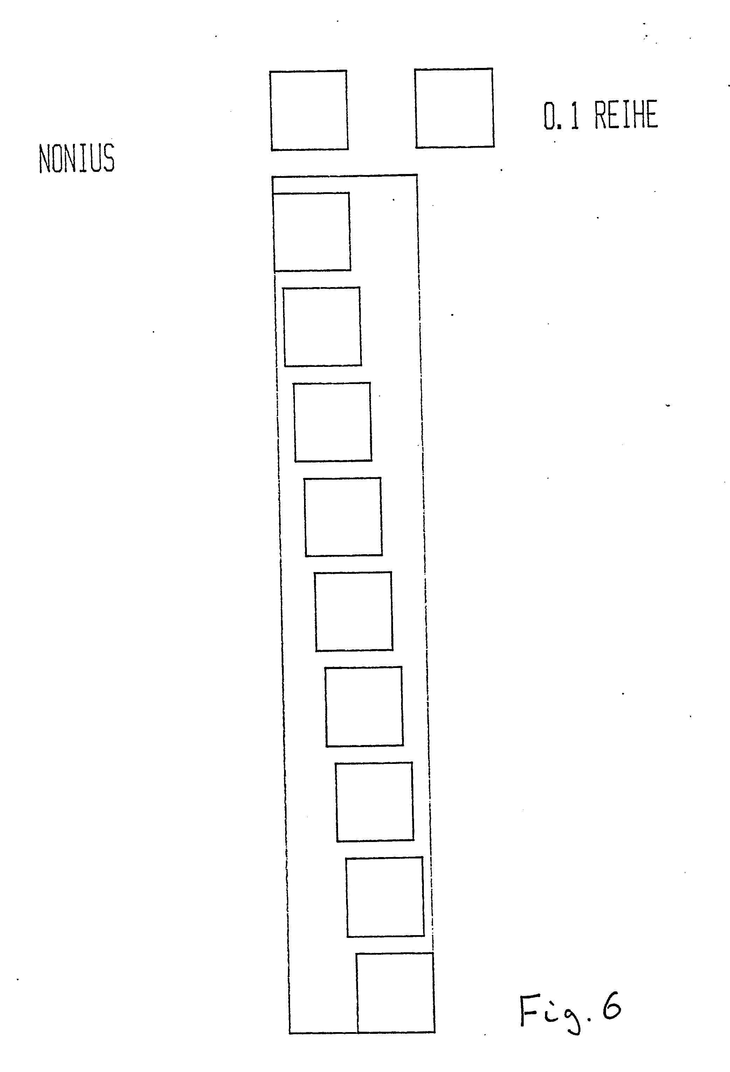

Neun Spuren werden bei einer linearen oder kreisförmigen Spur mit reduzierter Dichte nach dem Nonius-Prinzip (Fig. 6) magnetisiert. In Relation zu dem Wert 0,1 Grad ergibt sich dann immer 1 bit aus den 9 Noniusspuren, was das weitere 1/10 angibt. Eine Verschiebung um 1 Kommastelle entspricht 0,01 Winkelgrade.

Konstruktiv sind die Leseköpfe mit dem Gehäuse verbunden. Da keine Berührung mit der Magnetfläche vorhanden ist, geschieht das Ablesen ohne mechanische Belastung. Als Verarbeitung ist lediglich ein Operationsverstärker notwendig, um die Impulse zu verstärken und eine Zeitbasis für die Festlegung der aktuellen Information. Da die Werte als ASCII-Informationen abgelesen werden, entfällt eine Umarbeitung in einer Tabelle. Es sind lediglich die Werte bis auf den Nonius von den Leseköpfen zusammenzufassen in einem Register. Die Operation des Nonius ist einfach mit einer CPU zu lösen:

An der Innenseite des Zylinders 9 ist dicht an der Innenoberfläche eine Reihe von Magnetleseköpfen 4 befestigt. Diese Leseköpfe sind von derselben Bauart, wie sie bei Magnetplatten, Magnetbändern oder Magnetzylindern verwendet werden. Es handelt sich hier also um Induktionsmagnete mit einem Spalt nahe der Magnetschicht. Bewegt sich relativ zum Spalt eine magnetische Stelle vorbei, so wird in der Spule des Lesekopfes eine Spannung induziert.

Da die Leseköpfe nicht den gesamten Innenraum des Gehäuses 8 beanspruchen, kann in diesen Innenraum noch Elektronik 11 angeordnet werden, die an der Innenseite des Gehäuses 8 fest ist. Diese Bauweise wurde auch bei den anderen Ausführungsbeispielen genutzt.

Das Ablesen der Winkelinformation wird von Magnetleseköpfen vorgenommen, die auch in spezifikationsgleichen Magnetbandmaschinen, verwendet werden.

Die genannten Werte beziehen sich auf eine Magnetfläche von 182 mm Umfang, was etwa der Baugröße entspricht, die mit herkömmlichen Mitteln 0.1 Winkelgrade messen kann. Die abgerollte Fläche für ein 2 Lesekopfverfahren hat die Abmessungen: 182,8872 x 25,5 Millimeter.

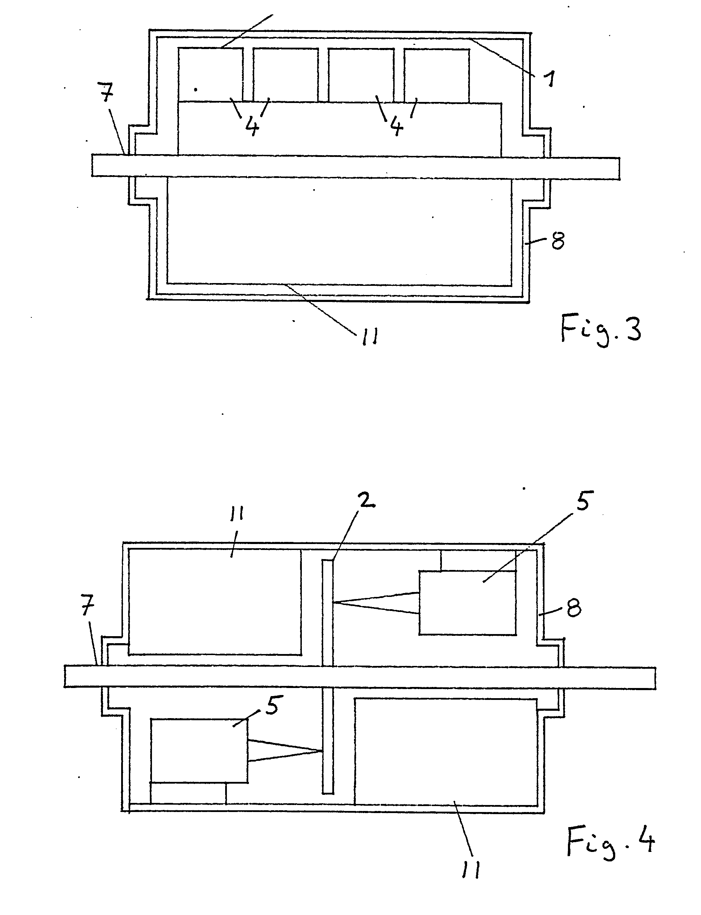

Das Ausführungsbeispiel nach Figur 3 weist wiederum ein zylindrisches Gehäuse 8 auf, in dem eine Achse 7 drehbar gelagert ist. Auf der Achse sind die Elektronik 11 und mehrere Magnetleseköpfe 4 befestigt, die nahe der Innenwandung des zylindrischen Mantels des Gehäuses 8 achsparallel angeordnet sind. Die zylindrische Innenwand des Gehäuses 8 trägt die Magnetschicht 1, die die Aufzeichnungsspuren bildet. Da hierdurch im Vergleich zur Baugröße mehr Umfang für die Aufzeichnung zur Verfügung steht, können die Winkelgeber besonders klein gebaut sein. Das gezeichnete System hat 4 Leseköpfe. Damit ist eine Genauigkeit ohne Nonius zu erreichen von 0.0125 Grd bei einer Geschwindigkeit von 125 Inch pro Sekunde = ca. 17 Umdrehungen oder Informationen aus einem Vollkreis per Sekunde.

Das Ausführungsbeispiel nach Figur 4 weist eine kreisscheibenförmige Platte 2, insbesondere aus Kunststoff, auf, auf deren einen oder beiden Seiten kreisförmige konzentrische Spuren aus Deformierungen angeordnet sind. Diese Deformierungen wurden durch einen Laserstrahl in der bekannten Digitaldisk-Technik hergestellt. Diese rechtwinklig auf der Achse 7 koaxial befestigte Platte 2 wird zu einer oder beiden Seiten von Laserleseköpfen 5 abgetastet, die über Fotoelemente bzw. Photodioden die Informationen der Aufzeichnungsspuren in Stromimpulse umwandeln. Die Aufzeichnungsdichte dieser Spuren ist extrem hoch, so daß sehr hohe Winkelgenauigkeiten erreichbar sind.

Besonders vorteilhaft ist es, wenn zur Bildung der Spur in nicht magnetischer Substanz, insbesondere Kunststoff eine Reihe von Vertiefungen eingebracht werden, die durch eine magnetische Substanz ausgefüllt sind. Dies geschieht nach dem Verfahren: Magnetic Molded Surfaces.

Die Laserleseeinheit als auch weitere Elektronikkomponenten sind an der Innenseite der Wand des zylindrischen Gehäuses 8 befestigt.

Die Impulse digitaler Art haben folgende Maße:
Tiefe: 0.0001 mm
Länge: 0.001-0.003 mm
Spurabstand: 0.0016 mm bezogen auf serielle Aufzeichnung
Breite: 0.0006 mm
Digits: 16 bit
Frequenz: 44.3 Kilohertz

Durchschnittlicher Impulsabstand ist ca. 0.0026 mm.
1 mm Aufzeichnung kann 384 Winkelinformationen tragen.

Bei einem Spurumfang von 182 mm = 69.888 Winkelinformationen pro Kreis; 0.005 Winkelgrade Auflösung.

Diese Berechnung ist nur gültig für einseitige Beschriftung der Codescheibe mit dem Laser. Eine weitere Steigerung der Genauigkeit läßt sich durch eine beidseitige Initalisierung der Codescheibe erreichen. Heir ist das Feld eines permanenten Nonius anwendbar, was als Ergebnis das Komma um eine Stelle weiter nach rechts rückt = 0.0005 Winkelgrade. Schwierigkeiten kann es in der Technik der Positionierung der Impulse geben, wenn das Medium von 2 Seiten benutzt wird, weil der Nonius synchron zum feinsten Raster der anderen Seite laufen muß. Es besteht aber die Möglichkeit den 2. Laser auch auf der gleichen Seite arbeiten zu lassen, was das Problem eliminiert.

Die Art der Aufschreibung ist wesentlich. Der Magnetlesekopf eines industriekompatiblen Bandes hat 16 Stellen + 2 Stellen Parity. Die Laserleser von Compact-Discs im Phonobereich ebenfalls.

Zum Magnet-Lesekopf:

Der Lesekopf hat die Form eines Würfels, dessen eine Fläche halbkreisförmig nach außen hin abgerundet ist. Auf dieser halbzylindrischen Fläche ist in Längsrichtung ein Schlitz eingefräst von ca. 0.001 mm Spaltenbreite. Im Innern sind 16 + 2 Wicklungen mit Magnetaustritt über den Spalt des Gehäuses, das aus Metall ist. Aus diesem Spalt können 16 + 2 Magnetspuren gelesen werden. Die aufgefangenen Impulse werden vestärkt und an die Verarbeitung weitergegeben.

Codes und Aufzeichnungsverfahren:

Es wird vorzugsweise ein ASCII - Code 4 bit für alle darstellbaren Zahlen verwendet. Bei einem Magnetlesekopf können 16 + 2 Stellen gleichzeitig gelesen werden. Logisch teilen sich diese 16 Stellen in 4 x 4 Charakter auf.

1. 4 Stellen für 0-1-2-3 - Hunderter Winkel-oder Wegstreckenangabe
4 Stellen 0-9 Zehner Winkel-oder Wegstreckenangabe
4 Stellen 0-9 Einer Winkel-oder Wegstreckenangabe
4 Stellen 0-9 erste Nachkommastelle
jeweils 8 Stellen werden mit Parity zusammengefaßt und über ECC (Error Correction Code) überprüft.

Winkel-oder Wegstreckenangabe xxx,x d.h. der gesamte Inhalt einer Winkel-oder Wegstreckenangabe wird in einem Takt bereits in dem Code der Weiterverarbeitung gelesen. Dieses Verfahren kann als absolut bezeichnet werden, weil der Winkel oder die Strecke ohne weitere Verarbeitung nur noch abzulesen ist.

Bei einem Winkelgeber ist die kleinste Einheit z.B. 133.2 Grad entsprechend 3600 komplett vorhandenen Winkelangaben auf dem Medium. Für größere Genauigkeit, insbesondere auch bei Wegstreckenmessern, kann folgendes Verfahren angewandt werden: Es wird ein 2. Lesekopf verwendet mit einer entsprechenden 2. Spur von ACII-Impulsen. Da die Dichte der Aufzeichnung der Impulse nicht endlos verfeinert werden kann, muß ein Verfahren angewendet werden, das sich wie folgt beschreiben läßt:

16 bits stehen zur Verfügung für den 2. Kopf. Diese 16 Felder werden als Nonius benutzt. D.h. der Abstand von 0.1 Winkelgrad-Feld zum nächsten Feld wird mit 9 Feldern in Leserichtung erweitert. Diese Felder sind jeweils um 1/9 des Feldabstands 0.1 versetzt (Fig. 6). Die Logik muß abfragen, welches Feld den kompletten Impuls liefert, dann kann anhand der Nummer des Feldes der 0.01 Anteil der Ablesewert addiert werden. Auf diese Weise kann diese Magnetverfahren 0.01 Winkelgrade ablesen, ohne die Rasterung zu ändern, was aufgrund der maximalen Impulsdichte ohnehin nicht geht. Die Logik muß nur feststellen, welche Drehrichtung anliegt: aufsteigende Winkelfolgen = Addition; abnehmende Zahlenfolgen = Subtraktion.

Für die Magnetleser ergibt sich folgende Berechnung: 8000 bits pro inch-16 + 2 bit breite Aufzeichnung. 19.68 16bit breite Informationen auf 1 Millimeter bei einem Zylinder-Innen-Umfang von 189.4737 mm stehen 3600 Informationszeilen zur Verfügung.
Mit einem Lesekopf = xxx,x Winkelgrade.
Mit einem 2. Kopf = xxx,xx Winkelgrade.
Die maximale Geschwindigkeit beträgt 125 IPS = 125 inches pro second = 3175 mm Sekunde = 16.7 Umdrehungen in der Sekunde = ca. 1000 U/Min.

Für die Lasertechnologie ergibt sich folgendes Bild: Abstand der Impulse voneinander = 0.0026 mm. Bei gleicher Fläche von 189.4737 mm stehen mit 1 Leseeinheit 72.874 Impulsreihen zur Verfügung = 72.874 x 16 + 2bit Informationen. Zwischen jeder vollen Winkelgrad-oder Wegstreckenangabe stehen 202 Informationen zur Verfügung. 0.004950 Winkelgrade oder Wegstrecken können als kleinstes Raster mit einer Leseeinheit erreicht werden. Die 2. Leseeinheit kann mit einem Nonius arbeiten auf einer 2. Spur, die auf der Außenseite liegt, wegen der besseren Verhältnisse. Somit kann das Komma noch um eine Stelle weiter rechts stehen = 0.0005 Winkelgrade oder Wegstrecken als kleinste Zähleinheit.

Ein vollständiger Wegstreckenmesser ist in den Zeichnungen nicht dargestellt. Die Spur des Wegstreckenmessers kann von einer Magnetschicht mit permanent magnetisierten Stellen oder von einer Kunststoffoberfläche mit Vertiefungen oder Erhebungen gebildet sein. Im ersteren Fall wird die Spur von einem Magnetlesekopf, im zweiten Fall von einem Laser gelesen.

**Ansprüche**

1. Wegstreckenmesser oder Winkelgeber mit zwei zueinander beweglichen Teilen, von denen ein Teil ein Leseteil und das andere Teil eine Spur trägt, wobei die Spur dem Leseteil Informationen übergibt, die die Stellung der Spur zum Leseteil angeben,
**dadurch gekennzeichnet,** daß die Spur von einer Magnetschicht (1) gebildet und von einem Computer lesbar ist, daß die Informationen der Spur den Strecken-bzw. Winkelgraden entsprechen, und daß das Leseteil einen auf magnetische Stellen ansprechenden Lesekopf (4) aufweist.

2. Wegstreckenmesser oder Winkelgeber mit zwei zueinander beweglichen Teilen, von denen ein Teil ein Leseteil und das andere Teil eine Spur trägt, wobei die Spur dem Leseteil Informationen übergibt, die die Stellung der Spur zum Leseteil angeben,
**dadurch gekennzeichnet,** daß die Spur von einer Fläche (2) gebildet ist, die von einem Laser mit von einem Computer erzeugten, insbesondere binären Zeichen beschrieben ist, die den Strecken-bzw. Winkelgraden der Spur entsprechen, und daß das Leseteil (5) einen Laser aufweist.

3. Wegstreckenmesser oder Winkelgeber mit zwei zueinander beweglichen Teilen, von denen ein Teil ein Leseteil und das andere Teil eine Spur auf einer transparenten Fläche trägt, wobei die Spur dem eine Photodiode aufweisenden Leseteil Informationen übergibt, die die Stellung der Spur zum eine Photodiode aufweisenden Leseteil angeben,
**dadurch gekennzeichnet,** daß die transparente Fläche (3) mit von einem Computer erzeugten binären Zeichen versehen ist, die den Strecken-bzw. Winkelgraden der Spur entsprechen.

4. Wegstreckenmesser oder Winkelgeber nach einem der vorherigen Ansprüche,
**dadurch gekennzeichnet,** daß die Spur mit einem Code beschrieben ist, der ohne weitere Umrechnung eine direkte Information über die Stellung von Spur und Lesekopf zueinander gibt.

5. Wegstreckenmesser oder Winkelgeber nach Anspruch 4,
**dadurch gekennzeichnet,** daß der Code aus einer Folge gleicher Zeichen, insbesondere gleicher Bits besteht.

6. Wegstreckenmesser oder Winkelgeber nach Anspruch 4,
**dadurch gekennzeichnet,** daß der Code ein Dezimalcode ist.

7. Wegstreckenmesser oder Winkelgeber nach einem der vorherigen Ansprüche,
**dadurch gekennzeichnet,** daß die die Spur(en) aufweisende Fläche (3, 9) zylindrisch ist.

8. Wegstreckenmesser oder Winkelgeber nach Anspruch 7,
**dadurch gekennzeichnet,** daß die die Spur(en) aufweisende Fläche (3, 9) von der Außen-und/oder Innenseite eines Zylindermantels getragen ist.

9. Wegstreckenmesser oder Winkelgeber nach einem der Ansprüche 1 bis 6,
**dadurch gekennzeichnet,** daß die die Spur(en) aufweisende Fläche (2) kreisscheibenförmig ist.

10. Wegstreckenmesser oder Winkelgeber nach Anspruch 9,
**dadurch gekennzeichnet,** daß die die Spur aufweisende Fläche von einer und/oder beiden Seitenflächen einer Kreisscheibe (2) getragen ist.

11. Wegstreckenmesser oder Winkelgeber nach einem der vorherigen Ansprüche,
**dadurch gekennzeichnet,** daß der Träger der Spur aus Kunststoff ist.

12. Winkelgeber nach einem der vorherigen Ansprüche,
**dadurch gekennzeichnet,** daß die die Endlosspur aufweisende Fläche an der Drehachse (7) des Winkelgebers fest ist und mit dieser gegenüber dem Leseteil (4, 5, 6) und dem Gehäuse (8) verdrehbar ist.

13. Winkelgeber nach einem der Ansprüche 1 bis 11,
**dadurch gekennzeichnet,** daß das Leseteil (4) an der Drehachse (7) des Winkelgebers fest ist und mit dieser gegenüber der Endlosspur und dem Gehäuse (8) verdrehbar ist.

14. Wegstreckenmesser oder Winkelgeber nach Anspruch 2,
**dadurch gekennzeichnet,** daß zur Bildung der Spur in nicht magnetischer Substanz, insbesondere Kunststoff eine Reihe von Vertiefungen eingebracht sind, die durch eine magnetische Substanz ausgefüllt sind.

Fig. 1

Fig. 2

46168

Fig. 3

Fig. 4

46168

Fig. 5

46168

0 254 207

NONIUS

0.1 REIHE

Fig. 6